# EUROPÄISCHE PATENTSCHRIFT

(11) **EP 3 921 877 B1**
(45) Veröffentlichungstag und Bekanntmachung des Hinweises auf die Patenterteilung: **05.04.2023**
(21) Anmeldenummer: 20704834.9
(22) Anmeldetag: 10.02.2020
(51) Int. Cl.: H01L 41/047, H01L 41/083, H01L 41/277

(54) **VERFAHREN ZUR HERSTELLUNG EINES PIEZOELEKTRISCHEN STAPELAKTORS UND PIEZOELEKTRISCHER STAPELAKTOR**
METHOD FOR PRODUCING A PIEZOELECTRIC STACK ACTUATOR AND PIEZOELECTRIC STACK ACTUATOR
PROCÉDÉ DE PRODUCTION D'UN ACTIONNEUR D'EMPILE PIÉZOÉLECTRIQUE ET ACTIONNEUR D'EMPILE PIÉZOÉLECTRIQUE

(30) Priorität: 08.02.2019 DE 102019201650
(43) Veröffentlichungstag der Anmeldung: 15.12.2021
(73) Patentinhaber: PI Ceramic GmbH, 07589 Lederhose (DE)
(72) Erfinder: SPEER, Kevin, 07646 Mörsdorf (DE)
(74) Vertreter: Grünecker Patent- und Rechtsanwälte PartG mbB
(86) Internationale Anmeldenummer: PCT/EP2020/053299
(87) Internationale Veröffentlichungsnummer: WO 2020/161353

(56) Entgegenhaltungen:
- EP-A1- 1 793 430
- WO-A1-2008/105381
- WO-A1-2015/174651
- DE-A1-102004 012 284
- US-A- 4 752 712

## Beschreibung

Die Erfindung betrifft einen piezoelektrischen Stapelaktor sowie ein Verfahren zu dessen Herstellung.

Piezoelektrische Stapelaktoren aus alternierend angeordneten piezoelektrischen Schichten und Elektroden sind u.a. aus US 4,384,230, US 4,721,447 bekannt.

Die US 2010/0140379 A1, US 2006/0066178 A1 JP 2006-179525 A, JP 2006-216850 A, JP 2006-229068 A, US 2010/0139621 , US 7,309,945, US 4752712 A, WO2008/105381 A1, DE102004012284 A1, WO2015174651 A1, EP1793430 A1 und DE102008041061 A1 offenbaren u.a. monolithische Blöcke aus piezoelektrischen Schichten und Elektroden, die einstückig versintert sind.

Aus der WO 2003/105246 A2 ist das Prinzip gezielt eingebrachter, kontrollierter Sollbruchstellen bekannt, um eine Spannungsakkumulation bei monolithischen Aktoren zu verhindern.

Gemäß einer alternativen Bauform, die Ausgangspunkt für die Erfindung darstellt, werden die piezoelektrischen Stapelaktoren aus Aktoren zusammengesetzt, die für sich genommen bereits eine oder mehrere Piezokeramikschichten aufweisen und vorzugsweise als funktionsfähige Mehrschichtaktoren ausgebildet sind, sodass sich die Auslenkungen der einzelnen Aktoren in Stapelrichtung überlagern und addieren. Anders als monolithische Blöcke aus alternierend angeordneten piezoelektrischen Schichten und elektrischen Kontakten werden diese sog. Chipstapel geklebt, weil die Polarisation der Aktoren bei Temperaturen über 300°C verloren geht und ein Versintern folglich ausscheidet. Die Verklebung führt dazu, dass die Aktorsegmente im Stapelverbund durch den Klebstoff zwischen einzelnen Aktoren entlang der Stapelachse voneinander beabstandet sind. Zudem können großvolumige Aktoren aufgrund von Problemen beim Organikausbrand nicht zuverlässig defektfrei monolithisch hergestellt werden. Das Verkleben begünstigt außerdem den Aufbau von Stapeln flexibler Länge mit minimaler Produktionszeit.

Die WO 2006/100247 A1 offenbart eine stapelförmige Anordnung von Mehrschichtaktoren, wobei die Aktoren durch vollflächige Verklebung über eine wärmeleitende Metallschicht verbunden sind.

Bei Stapelaktoren, bei denen die benachbarten piezoelektrischen Schichten vollflächig verbunden sind, kommt es bei elektrischer Ansteuerung zu mechanischen Spannungen im Stapel, da sich die aneinander gekoppelten piezoelektrischen Schichten in ihrer Verformung gegenseitig blockieren. Dieses Problem verstärkt sich mit zunehmender Stapelhöhe.

Bei der Herstellung solcher Stapelaktoren, die auch als geklebte Chipstapel aus ein- oder mehrschichtigen Aktoren bezeichnet werden, kann es zu unkontrollierter Rissbildung kommen. Diese tritt auf, obwohl die Einzelsegmente zuvor zu 100 % polarisiert und auf Funktionalität und Risse geprüft wurden. Nach dem Verkleben dieser rissfreien Aktoren (Chips) und erneuter Ansteuerung treten dann Risse in der äußeren passiven Isolationsschicht der Aktoren (Chips) auf.

Diese Risse beeinträchtigen die Widerstandsfähigkeit bzw. die Lebensdauer der Aktoren, insbesondere in feuchter Umgebung. Im Zuge der Qualitätskontrolle werden die betroffenen Teile deshalb in der Regel aussortiert und verursachen damit Ausfallkosten. Weiterhin wird damit die Fertigungsplanung durcheinandergebracht, da die zum Ausfall führenden Risse erst am Ende eines insgesamt mehrwöchigen Prozesses auftreten.

Auch bei in der Warenausgangskontrolle rissfreien Aktoren treten regelmäßig unter Anwendungsbedingungen, insbesondere bei dynamischem Betrieb, Risse in der passiven Randschicht auf. Diese beeinträchtigen die Zuverlässigkeit bzw. Lebensdauer in gleicher Weise und können damit im Extremfall zum Stillstand aufwändiger Produktionsanlagen führen. Besonders kritisch auf die Lebensdauer von Aktoren wirkt sich ein Mischbetrieb aus statischen und dynamischen Lasten aus. Durch die Wechselbelastung werden Risse in der passiven Schicht begünstigt, die dann beim statischen Betrieb, ohne Eigenerwärmung des Aktors, durch eintretende Feuchtigkeit Elektromigration als Schädigungsmechanismus ermöglichen.

Ein weiterer kritischer Betriebsmodus ist die Ansteuerung mit niedrigen Frequenzen (einige Hz), wobei es nicht zur Eigenerwärmung über Umgebungstemperatur des Aktors kommt und somit Feuchtigkeit in direkter Aktornähe vorhanden sein kann und die Wechselbelastung zum anderen die Rissentstehung fordert.

Die Häufigkeit derartiger Risse nimmt erfahrungsgemäß mit wachsendem Aktorquerschnitt zu.

Auch bei Hochvoltaktoren, bei denen einschichtige Aktoren und Kontaktbleche alternierend stapelförmig angeordnet und miteinander verklebt sind, kommt es zu Kurzschlüssen infolge von Rissen im Randbereich der Aktorsegmente bzw. am Übergang zwischen aktivem und passivem Bereich. Im Gegensatz zu Mehrschichtaktoren erfordern die Einschichtaktoren höhere Spannungen, um das piezokeramische Material zur Erzeugung einer Deformation elektrisch anzusteuern.

Der vorliegenden Erfindung liegt die Aufgabe zugrunde, die zuvor beschriebene Rissbildung zu verhindern, um damit die Lebensdauer eines aus einzelnen Aktoren aufgebauten, piezoelektrischen Stapelaktors insbesondere beim Einsatz in feuchter Umgebung, zu erhöhen.

Die Aufgabe wird gelöst durch das Verfahren zur Herstellung eines piezoelektrischen Stapelaktors nach Anspruch 1.

Erfindungsgemäß wird der piezoelektrische Stapelaktor durch Kopplung einzelner Aktoren hergestellt. Aus diesen bereits funktionsfähigen Aktoren kann mit geringem Aufwand ein piezoelektrischer Stapelaktor aufgebaut werden, der eine deutlich größere Auslenkung entlang der Stapelachse erzielt als jeder einzelne Aktor. Ferner können die Stapelaktoren aus den funktionsfähigen Einzelaktoren wesentlich einfacher hergestellt werden als ein Stapelaktor, der als monolithischer Block ausgebildet ist und eine erhebliche axiale Erstreckung aufweist.

In jedem Aktor kommt es bei Ausdehnung zu Zugspannungen im sog. passiven Bereich ohne Elektroden, da dieser sich im Gegensatz zum sog. aktiven Bereich nicht mit dehnt. Aufgrund der geringen Höhe der Aktoren und einer Deformation der passiven Bereiche liegt die Zugspannung bei jedem einzelnen Aktor unterhalb einer kritischen Belastung. Bei vollflächiger Kopplung der benachbarten Aktoren sind Verformungen der passiven Bereiche aber nicht mehr möglich, weil diese bezüglich der Kopplungsebene in unterschiedliche Richtungen erfolgen und sich demnach gegenseitig blockieren. Der Effekt verstärkt sich immer weiter, je mehr Aktoren übereinander geklebt werden. Die durch die Deformation entstehenden Spannungen addieren sich somit und überschreiten die Festigkeit der passiven Bereiche. An Schwachstellen kommt es damit zur Rissbildung.

Die Lösung der eingangs gestellten Aufgabe besteht sinngemäß darin, die benachbarten Aktoren vorzugsweise im Randbereich gezielt voneinander zu entkoppeln. Erfindungsgemäß werden die einzelnen Aktoren über eine Kopplungsfläche aneinandergekoppelt, die kleiner ist als eine Projektionsfläche des Aktors auf eine senkrecht zur Stapelachse stehende Ebene. Die Kopplungsfläche entspricht vorzugsweise in ihrer flächigen Ausdehnung derjenigen des aktiven Bereichs des Aktors, d. h. der flächigen Ausdehnung des Stapelaktors in einer Ebene senkrecht zur Stapelachse, abzüglich der Fläche des passiven Bereichs. Der passive Bereich befindet sich in der Regel am Rand des Aktors. Die hier zum Einsatz kommenden Aktoren bestehen selbst aus ein- oder mehrschichtigen Paketen mit alternierend angeordneten Piezokeramikschichten und Elektroden/Kontakten, die sich parallel zueinander in Ebenen senkrecht zur Stapelachse erstrecken, um im Ergebnis eine Auslenkung entlang der Stapelachse zu erzeugen. Der von den Elektroden/Kontakten abgedeckte und elektrisch angesteuerte Bereich der Piezokeramikschichten definiert den sogenannten aktiven Bereich des Aktors, der sich bei elektrischer Ansteuerung aktiv verformt. Nicht angesteuerte Bereiche der Piezokeramikschichten (ohne Elektroden), die sich bei elektrischer Ansteuerung der Aktoren nicht aktiv, sondern ggf. passiv verformen, werden als Isolierung, Isolierschicht oder passiver Bereich bezeichnet.

Durch die gezielte Kopplung bzw. Entkopplung der Aktoren über die Kopplungsfläche werden die Lastspitzen in den passiven Bereichen der aneinandergekoppelten Aktoren abgebaut, sodass die eingangs erwähnte Rissbildung effektiv verhindert werden kann und die Lebensdauer der nach dem erfindungsgemäßen Verfahren hergestellten Stapelaktoren deutlich erhöht wird.

Vorteilhafte Weiterbildungen sind Gegenstände der Unteransprüche.

Es kann von Vorteil sein, wenn Schritt A wenigstens einen der folgenden Teilschritte aufweist:
- Teilschritt A1: Bereitstellen von Piezokeramikschichten und elektrischen Kontakten zum Aufbau der Aktoren, vorzugsweise als Einzelschichtaktor oder als Mehrschichtaktor. Derartige Bauelemente für Stapelaktoren sind in der Regel kostengünstig verfügbar und können zur Herstellung verschieden großer Stapelaktoren verwendet werden. Die elektrischen Kontakte zum elektrischen Ansteuern der Piezokeramikschichten werden auch als Elektrodenschichten oder Innenelektroden bezeichnet. Die flächige Erstreckung der elektrischen Kontakte bzw. Innenelektroden ist vorzugsweise kleiner als die flächige Erstreckung der Piezokeramikschichten. Im Stapelverbund sind die Randbereiche der Piezokeramikschichten dann nicht mit elektrischen Kontakten bzw. Innenelektroden bedeckt und werden auch nicht elektrisch angesteuert. Dadurch verformen sich diese Randbereiche der Piezokeramikschichten nicht aktiv, sondern ggf. passiv, und bilden den passiven Bereich des Aktors, der auch als "Isolierung" bzw. "Isolierschicht" bezeichnet wird. Diese keramische "Isolierung" bzw. "Isolierschicht" gewährleistet einen effektiven und dauerhaften Schutz insbesondere der Innenelektroden, auch in feuchter Umgebung. Durch die erfindungsgemäße Kopplung der Aktoren über die Kopplungsfläche kann diese effektive aber sprödharte Schutzschicht aus Keramik vor Defekten bewahrt werden.
- Teilschritt A2: Stapeln der Piezokeramikschichten entlang einer Achse, vorzugsweise derart, dass zwei benachbarte Piezokeramikschichten unter Zwischenschaltung jeweils eines elektrischen Kontakts, bevorzugt einer Elektrodenschicht oder eines Kontaktblechs, mit Polen gleicher Polarität zueinander weisen. Diese Bauart weist sich als besonders kompakt und günstig im Hinblick auf den Anschluss der Piezokeramikschichten zur elektrischen Ansteuerung.
- Teilschritt A3: Verbinden der elektrischen Kontakte mit Elektroden entsprechender Polarität, wobei die Elektroden unterschiedlicher Polarität vorzugsweise umfangsseitig am Aktor beabstandet voneinander angeordnet sind, bevorzugt sich auf diametral entgegengesetzten Seiten des Aktors befinden. Die hier genannten Elektroden werden unter anderem auch als Seitenelektroden oder Außenelektroden bezeichnet.
- Teilschritt A4: Umhüllen der Piezokeramikschichten und der elektrischen Kontakte mit keramischem Isolierstoff, wobei die Umhüllung mit Isolierstoff bevorzugt luftdicht und/oder feuchtigkeitsdicht ist. Diese Bauart begünstigt insbesondere den Einsatz der Aktoren in feuchter Umgebung.
- Teilschritt A5: Ausbilden mindestens einer Kopplungsfläche zur Kraftkopplung des Aktors mit einem benachbarten Aktor, vorzugsweise nach wenigstens einem der folgenden Teilschritte:
   o Teilschritt A5-1: Ausbilden wenigstens einer Kopplungsfläche im aktiven Bereich des Aktors. Der aktive Bereich des Aktors ist mit Elektroden durchsetzt bzw. von Elektroden bedeckt und wird durch die elektrische Ansteuerung der Elektroden aktiv deformiert. Der Rand des Aktors um den aktiven Bereich bildet den sogenannten passiven Bereich, der durch elektrische Ansteuerung der Piezokeramikschichten nicht aktiv verformt wird, sondern der Verformung des aktiven Bereichs passiv folgt. Im passiven Bereich sind Lastabbauabschnitte, die sich durch Verkleinerung der Kopplungsfläche gegenüber einer Erstreckung des Aktors in einer senkrecht zur Achse stehenden Ebene ergeben, besonders wirkungsvoll, weil sie eine passive Verformung der Isolierung der aneinandergekoppelten Aktoren zulassen und somit Lastspitzen im Bereich der Isolierung abbauen. Nach diesem Merkmal schließt der aktive Bereich die Kopplungsfläche ein, d.h. die Kopplungsfläche liegt im aktiven Bereich. In anderen Worten ausgedrückt, befindet sich die Kopplungsfläche bei Projektion auf eine senkrecht zur Stapelachse stehende Ebene vollständig innerhalb der Projektionsfläche der elektrischen Kontakte bzw. Innenelektroden.
   ∘ Teilschritt A5-2: Ausbilden wenigstens einer Kopplungsfläche an einem zwischen zwei zu koppelnden Aktoren anzuordnenden Zusatzelement, wobei das Zusatzelement vorzugsweise als Elektrode ausgebildet ist. Bei dieser Bauart können z.B. zylindrisch oder quaderförmig aufgebaute Aktoren ohne stirnseitige Reduzierung der Erstreckung des Aktors in einer senkrecht zur Achse stehenden Ebene über Zusatzelemente aneinander gekoppelt werden, wobei die Zusatzelemente eine passive Verformung der Isolierung der aneinandergekoppelten Aktoren zulassen und somit Lastspitzen im Bereich der Isolierung abbauen. Bei der Ausbildung als Elektrode können die Piezokeramikschichten über das Zusatzelement elektrisch angesteuert werden, Diese Ausführung eignet sich insbesondere für den Aufbau von sog. Hochvoltstapeln.
   ∘ Teilschritt A5-3: Ausbilden der Kopplungsfläche an einem oder beiden axialen Ende(n) des Aktors bzw. des Zusatzelements, vorzugsweise derart, dass die Kopplungsfläche eines der oder beide axialen Enden des Aktors bzw. des Zusatzelements bildet. Bei dieser Ausführung gestaltet sich die Kopplung der Aktoren besonders einfach.
   ∘ Teilschritt A5-4: Ausbilden der Kopplungsfläche unter Formung einer Fase oder Stufe zu einem angrenzenden und/oder umliegenden Bereich, vorzugsweise einem Randbereich des Aktors bzw. des Zusatzelements. Mit diesen Ausführungsformen lässt sich die Kopplungsfläche beispielsweise durch geringfügigen Materialabtrag oder Materialauftrag an der Stirnseite der Aktoren besonders einfach erzeugen.
   ∘ Teilschritt A5-5: Ausbilden der Kopplungsfläche, sodass die Kopplungsfläche bei Projektion auf eine senkrecht zur Stapelachse stehende Ebene vollständig innerhalb der Projektionsfläche des Aktors liegt und vorzugsweise vollumfänglich von der Projektionsfläche umschlossen ist. In dieser Ausführung sind die passiven Randbereiche benachbarter Aktoren voneinander entkoppelt, sodass deren passive Verformung bei elektrischer Ansteuerung der Aktoren ermöglicht wird und Lastspitzen im Bereich der passiven Randbereiche abgebaut werden.
   ∘ Teilschritt A5-6: Ausbilden der Kopplungsfläche in einer Ebene, die sich senkrecht zur Achse erstreckt. Bei dieser Bauart ist eine besonders einfache Kopplung der Aktoren möglich.
   ∘ Teilschritt A5-7: Ausbilden der Kopplungsfläche (K), sodass in Bezug auf die Projektionsfläche (P) des Aktors folgendes Flächenverhältnis gilt: 0,7*P ≤ K < P, vorzugsweise 0,8*P ≤ K ≤ 0,99*P, bevorzugt 0,9*P ≤ K s 0,95*P. Die Kopplungsfläche weist idealerweise dieselbe flächige Erstreckung auf wie die Elektroden bzw. der aktive Bereich des Aktors oder ist etwas kleiner, sodass der passive Bereich des Aktors, welcher sich bei Projektion auf eine senkrecht zur Achse stehende Ebene radial außerhalb der Elektroden befindet, außerhalb der Kopplungsfläche liegt. Mit anderen Worten ist der entkoppelte Bereich in der Kopplungsebene außerhalb der Kopplungsfläche im Wesentlichen oder exakt so breit wie der passive Bereich des Aktors, oder etwas größer. Dadurch kann über die Kopplungsfläche einerseits eine ideale Kraftkopplung zwischen den Aktoren im aktiven Bereich des Aktors bewerkstelligt werden, während der passive Randbereich des Aktors zur Ermöglichung einer passiven Verformung der Piezokeramikschichten ideal entkoppelt wird.
   ∘ Teilschritt A5-8: Ausbilden der Kopplungsfläche als Fläche, die von der Achse durchstoßen wird und/oder konzentrisch zur Achse angeordnet ist, wobei die Kopplungsfläche vorzugsweise kreisförmig oder ringförmig ausgebildet ist. Bei dieser Ausführung können Lastspitzen besonders effektiv abgebaut werden, da auf die Isolierung einwirkende Lasten besonders gleichmäßig über den gesamten Umfang der Kopplungsfläche verteilt werden.
   ∘ Teilschritt A5-9: Ausbilden der Kopplungsfläche aus Klebstoff. Bei dieser Ausführung ist die Klebefläche zwischen zwei Aktoren kleiner als die flächige Erstreckung der Aktoren senkrecht zur Stapelachse.
- Teilschritt A6: Bereitstellen von wenigstens zwei identischen Aktoren. Bei dieser Ausführung gestaltet sich der Aufbau des Stapelaktors besonders einfach.

Es kann aber auch hilfreich sein, wenn Schritt B wenigstens einen der folgenden Teilschritte aufweist:
- Teilschritt B1: Anordnen der wenigstens zwei Aktoren mit regelmäßiger und/oder identischer Ausrichtung bezüglich der Stapelachse, vorzugsweise derart, dass die Elektroden der Aktoren mit gleicher Polarität in einer Linie parallel zur Stapelachse ausgerichtet sind und/oder dass die einander zugewandten Seiten benachbarter Aktoren parallel sind. Bei dieser Bauform gestaltet sich der Aufbau des Stapelaktors ebenfalls besonders einfach, da insbesondere die Elektroden der einzelnen Aktoren leicht miteinander verbunden werden können.
- Teilschritt B2: Anordnen eines Zusatzelements zwischen zwei benachbarten Aktoren. In dieser Ausführungsform können insbesondere zylindrische oder quaderförmige Einzelaktoren ohne gesonderte Formung einer Kopplungsfläche, die gegenüber der flächigen Erstreckung des Aktors in einer senkrecht zur Achse stehenden Ebene verkleinert ist, besonders einfach aneinander gekoppelt werden.
- Teilschritt B3: Verbinden der wenigstens zwei Aktoren, sodass jeweils zwei benachbarte Aktoren unmittelbar wirkverbunden oder mittelbar über ein Zusatzelement wirkverbunden sind, vorzugsweise unter Ausbildung einer stoffschlüssigen Verbindung zwischen den benachbarten Aktoren oder zwischen jedem der benachbarten Aktoren und dem dazwischen angeordneten Zusatzelement, bevorzugt durch Klebstoff, wobei besonders bevorzugt der Klebstoff die mindestens eine Kopplungsfläche vollständig verklebt. Bei dieser Bauform werden die Piezokeramikschichten im Gegensatz zum eingangs erwähnten Stand der Technik nicht zu einem monolithischen Block verbunden, beispielsweise durch Sintern, sondern der Stapelaktor wird durch Stapeln und Koppeln funktionsfähiger Einzelaktoren, die vorzugsweise miteinander verklebt sind, aufgebaut. Demnach sind die Piezokeramikschichten des Stapelaktors paketweise angeordnet und durch den Klebstoff zwischen den aneinandergekoppelten Aktoren in Achsrichtung voneinander beabstandet.
- Teilschritt B4: Entkoppeln zweier Aktoren außerhalb der mindestens einen Kopplungsfläche, vorzugsweise im Randbereich, bevorzugt in der Kopplungsebene, besonders bevorzugt durch Entfernen von piezokeramischem Material und/oder Klebstoff und/oder Auftragen von Trennmittel. Gemäß dieser Ausführungsform kann die Kopplungsfläche, die gegenüber der flächigen Erstreckung des Aktors in einer senkrecht zur Achse stehenden Ebene verkleinert ist, auch nach dem Koppeln der Aktoren herausgearbeitet werden, beispielsweise durch gezielten Materialabtrag an den Piezokeramikschichten oder durch gezielten Materialabtrag an einem zwei benachbarte Piezokeramikschichten verbindenden Material. Durch ein Auftragen von Trennmittel in den zu entkoppelnden Bereichen außerhalb der Kopplungsfläche kann das rückstandsfreie Entfernen von Klebstoff begünstigt werden. Es ist ebenfalls denkbar, dass der entkoppelte Bereich nachträglich mit einem weichen Material aufgefüllt wird, welches eine passive Verformung der passiven Bereiche der Aktoren zulässt, während die Kraftkopplung der Aktoren weiterhin über die Kopplungsfläche erfolgt.
- Teilschritt B5: Verbinden der Elektroden der Aktoren mit derselben Polarität untereinander durch einen Verbindungsabschnitt, vorzugsweise durch Aufbringen des Verbindungsabschnitts auf die Elektroden. Durch diesen Verbindungsabschnitt können die Seitenelektroden der Einzelaktoren besonders einfach angeschlossen werden. Im Regelfall genügt pro Aktor eine einzelne Kontaktstelle. Es sind jedoch auch mehrere Verbindungsstellen oder eine linienartige Verbindung über die gesamte Segmenthöhe denkbar.

Die eingangs gestellte Aufgabe wird ebenfalls gelöst durch einen piezoelektrischen Stapelaktor gemäss dem Anpruch 4.

Es kann überdies hilfreich sein, wenn jeder der Aktoren wenigstens eines der folgenden Merkmale aufweist:
- Der Aktor ist aus Piezokeramikschichten und elektrischen Kontakten aufgebaut, vorzugsweise als Einzelschichtaktor oder als Mehrschichtaktor.
- Die Piezokeramikschichten sind entlang einer Achse gestapelt, vorzugsweise derart, dass zwei benachbarte Piezokeramikschichten unter Zwischenschaltung jeweils eines elektrischen Kontakts, bevorzugt einer Elektrodenschicht oder eines Kontaktblechs, mit Polen gleicher Polarität zueinander weisen.
- Die elektrischen Kontakte sind mit Elektroden entsprechender Polarität verbunden, wobei die Elektroden unterschiedlicher Polarität vorzugsweise umfangsseitig am Aktor beabstandet voneinander angeordnet sind, bevorzugt sich auf diametral entgegengesetzten Seiten des Aktors befinden.
- Die Piezokeramikschichten und die elektrischen Kontakte sind mit keramischem Isolierstoff umhüllt, wobei die Umhüllung mit Isolierstoff bevorzugt luftdicht und/oder feuchtigkeitsdicht ist.

Es kann sich aber auch als nützlich erweisen, wenn die Kopplungsfläche wenigstens eines der folgenden Merkmale aufweist:
- Die wenigstens eine Kopplungsfläche ist in einem aktiven Bereich des Aktors ausgebildet.
- Die wenigstens eine Kopplungsfläche ist an einem zwischen zwei zu koppelnden Aktoren anzuordnenden Zusatzelement ausgebildet, wobei das Zusatzelement vorzugsweise als Elektrode ausgebildet ist.
- Die wenigstens eine Kopplungsfläche ist an einem oder beiden axialen Ende(n) des Aktors bzw. des Zusatzelements ausgebildet, vorzugsweise derart, dass die Kopplungsfläche eines der oder beide axialen Enden des Aktors bzw. des Zusatzelements bildet.
- Die wenigstens eine Kopplungsfläche ist unter Formung einer Fase oder Stufe zu einem angrenzenden und/oder umliegenden Bereich, vorzugsweise einem Randbereich des Aktors bzw. des Zusatzelements ausgebildet.
- Die wenigstens eine Kopplungsfläche ist derart ausgebildet, dass die Kopplungsfläche bei Projektion auf eine senkrecht zur Stapelachse stehende Ebene vollständig innerhalb der Projektionsfläche des Aktors liegt und vorzugsweise vollumfänglich von der Projektionsfläche umschlossen ist.
- Die wenigstens eine Kopplungsfläche ist in einer Ebene ausgebildet, die sich senkrecht zur Achse erstreckt.
- Die wenigstens eine Kopplungsfläche (K) ist derart ausgebildet, dass in Bezug auf die Projektionsfläche (P) des Aktors folgendes Flächenverhältnis gilt: 0,7*P ≤ K < P, vorzugsweise 0,8*P ≤ K ≤ 0,99*P, bevorzugt 0,9*P ≤ K ≤ 0,95*P.
- Die wenigstens eine Kopplungsfläche ist als Fläche ausgebildet, die von der Achse durchstoßen wird und/oder konzentrisch zur Achse angeordnet ist, wobei die Kopplungsfläche vorzugsweise kreisförmig oder ringförmig ausgebildet ist.
- Die wenigstens eine Kopplungsfläche ist aus Klebstoff ausgebildet.

Es kann auch praktisch sein, wenn der Stapelaktor wenigstens eines der folgenden Merkmale aufweist:
- Wenigstens zwei Aktoren sind mit regelmäßiger und/oder identischer Ausrichtung bezüglich der Stapelachse angeordnet, vorzugsweise derart, dass die Elektroden der Aktoren mit gleicher Polarität in einer Linie parallel zur Stapelachse ausgerichtet sind und/oder dass die einander zugewandten Seiten benachbarter Aktoren parallel sind.
- Wenigstens ein Zusatzelement ist zwischen zwei benachbarten Aktoren angeordnet.
- Wenigstens zwei benachbarte Aktoren sind unmittelbar wirkverbunden oder mittelbar über ein Zusatzelement wirkverbunden, vorzugsweise durch eine stoffschlüssige Verbindung zwischen den benachbarten Aktoren oder zwischen jedem der benachbarten Aktoren und dem dazwischen angeordneten Zusatzelement, bevorzugt durch Klebstoff, wobei besonders bevorzugt der Klebstoff die mindestens eine Kopplungsfläche vollständig verklebt.
- Wenigstens zwei benachbarte Aktoren sind mit Ausnahme der mindestens einen Kopplungsfläche voneinander entkoppelt, vorzugsweise im Randbereich, bevorzugt in der Kopplungsebene, besonders bevorzugt durch Entfernen von piezokeramischem Material und/oder Klebstoff und/oder durch Auftragen von Trennmittel vor dem Verkleben.
- Die Elektroden der Aktoren mit derselben Polarität sind untereinander durch einen Verbindungsabschnitt verbunden, wobei der Verbindungsanschnitt vorzugsweise auf die Elektroden aufgebracht ist.

Vorteilhafte Weiterbildungen ergeben sich durch Kombinationen der Merkmale, die in den Ansprüchen, der Beschreibung und den Zeichnungen offenbart sind.

### Begriffe und Definitionen

Die Begriffe "Isolationsschicht" und "Isolierung" beschreiben den passiven Bereich des Aktors. Dabei handelt es sich um den Randbereich der Piezokeramikschichten bzw. um piezokeramisches Material, das nicht durch die Elektroden elektrisch angeregt wird und sich demnach nicht verformt. Zusätzlich zu dieser "Isolationsschicht" und "Isolierung" aus piezokeramischem Material kann der Aktor eine Umhüllung aus Isolierstoff aufweisen.

### Kurze Beschreibung der Figuren

Es zeigen:

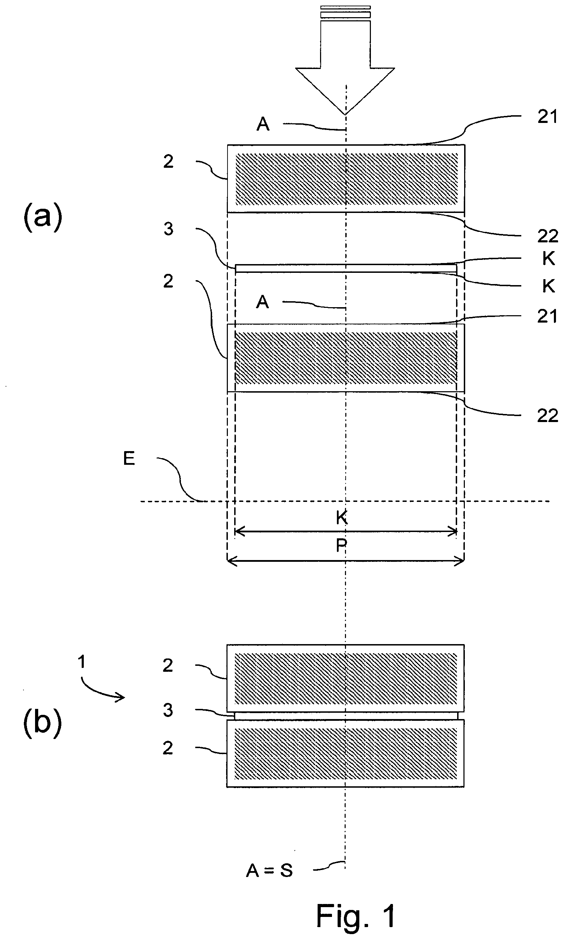

- Figur 1: schematische Ansichten der Schritte des erfindungsgemäßen Verfahrens zur Herstellung eines piezoelektrischen Stapelaktors, wobei Ansicht (a) eine Schnittansicht zweier Aktoren und eines zwischen den Aktoren einzubringenden Zusatzelements im unverbundenen Zustand zeigt und Ansicht (b) eine Schnittansicht der beiden Aktoren im mittelbar verbundenen Zustand mit zwischengeschaltetem Zusatzelement zeigt.

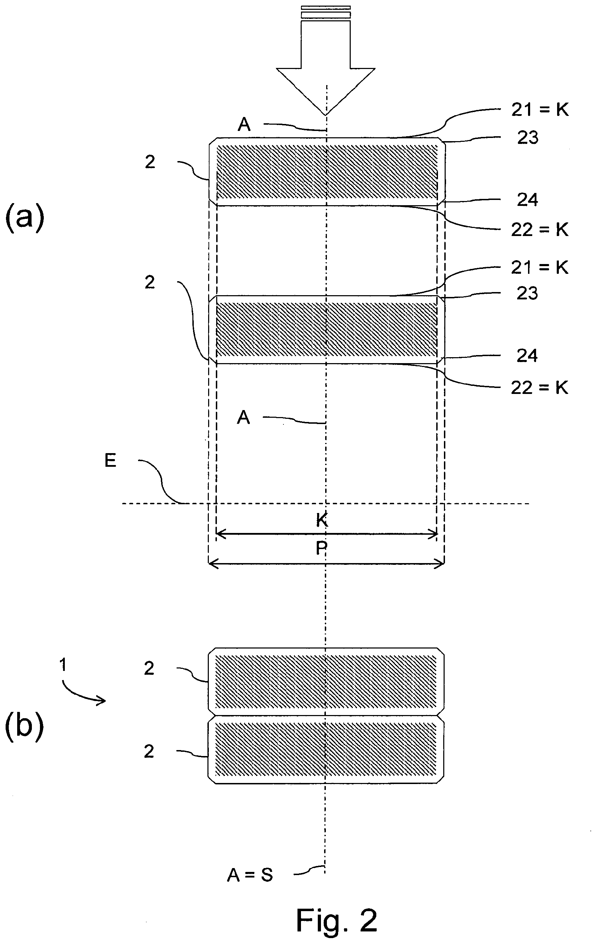

- Figur 2: schematische Ansichten der Schritte des erfindungsgemäßen Verfahrens zur Herstellung eines piezoelektrischen Stapelaktors, wobei im Unterschied zu Figur 1 die Oberseiten und Unterseiten der Aktoren gefast sind und die Aktoren ohne Zwischenschaltung eines Zusatzelements unmittelbar miteinander gekoppelt sind.

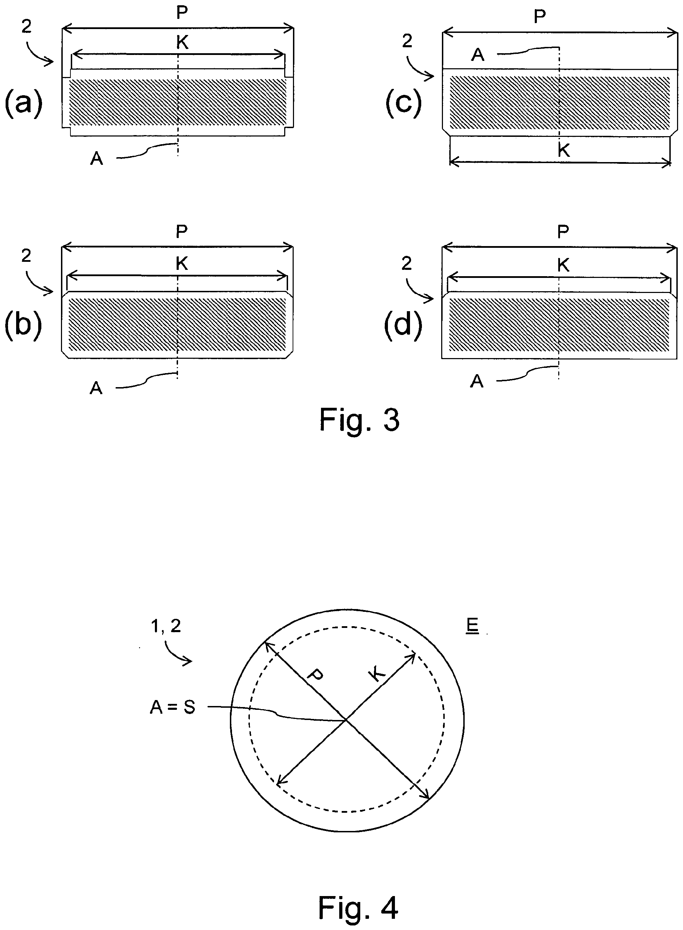

- Figur 3: in den Ansichten (a) bis (d) schematische Schnittansichten weitere Ausführungsformen von Aktoren, deren Kopplungsfläche kleiner ist als die Projektionsfläche des Aktors auf eine senkrecht zur Achse stehende Ebene.
- Figur 4: eine Draufsicht auf einen aus identischen Aktoren ausgebildeten, piezoelektrischen Stapelaktor, wobei die Aktoren entlang einer Stapelachse gestapelt sind, wobei die Kopplungsfläche zwischen benachbarten Aktoren kleiner ist als die Projektionsfläche der Aktoren auf eine senkrecht zur Achse bzw. Stapelachse stehende Ebene.

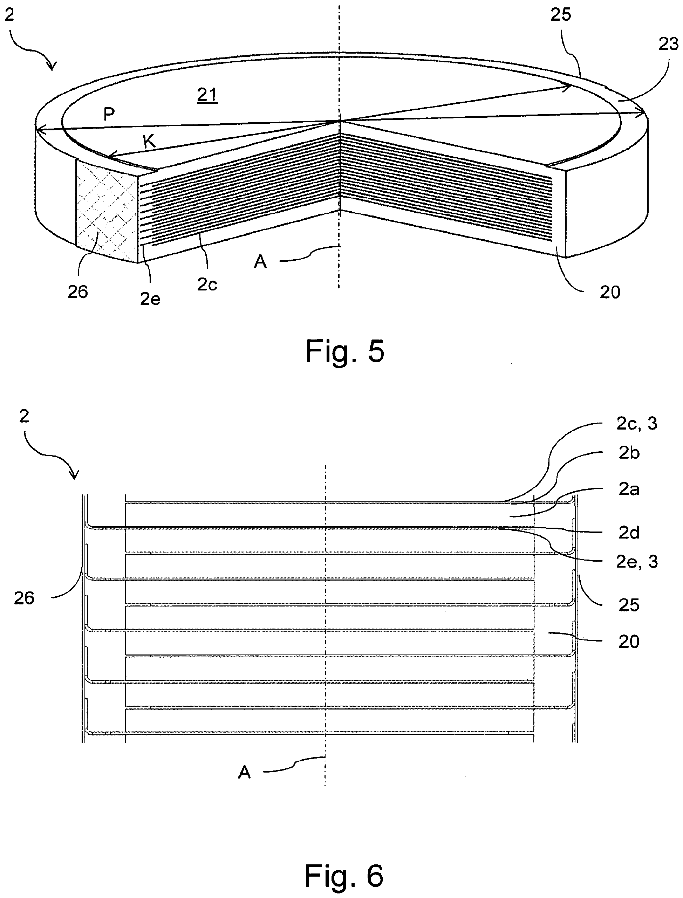

- Figur 5: eine perspektivische Ansicht eines im Teilschnitt dargestellten Aktors, der in dem erfindungsgemäßen Verfahren zur Herstellung eines piezoelektrischen Stapelaktors Verwendung findet.
- Figur 6: eine schematische Schnittansicht eines sog. Hochvoltstapels mit einschichtigen Aktoren aus Piezokeramik und elektrischen Kontakten (Innenelektroden) in Form von Kontaktblechen, wobei die Piezokeramikschichten unter Zwischenschaltung jeweils eines Kontaktblechs mit Polen gleicher Polarität zueinander weisend aufeinander gestapelt sind, wobei die Kontaktbleche an Außenelektroden bzw. Seitenelektroden angeschlossen sind, über welche die Piezokeramikschichten gleichzeitig angesteuerbar sind.

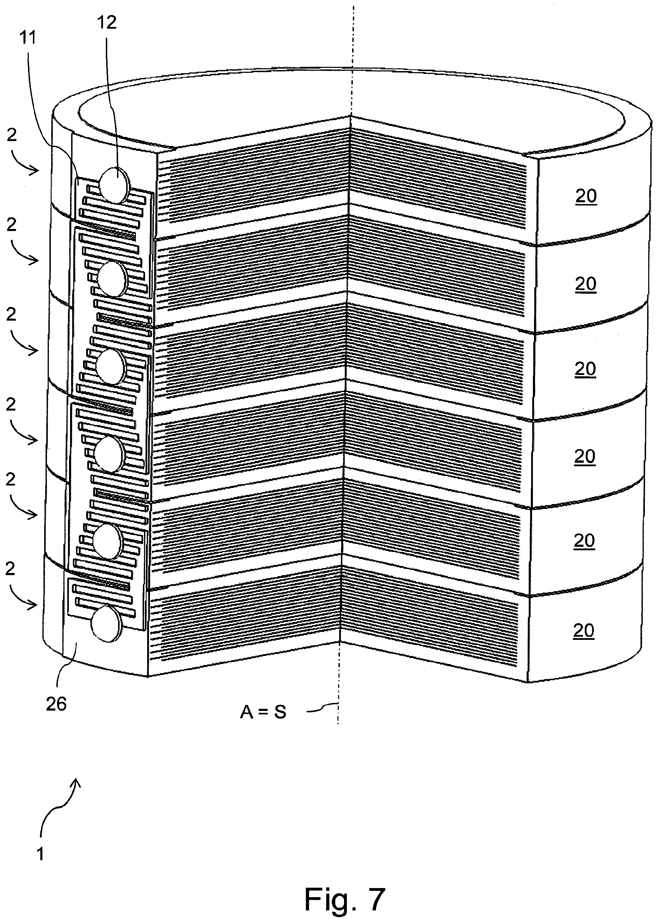

- Figur 7: eine perspektivische Ansicht eines im Teilschnitt dargestellten Stapelaktors, der aus einer Vielzahl von Aktoren gemäß Figur 5 hergestellt ist.

### Detaillierte Beschreibung der bevorzugten Ausführungsbeispiele

Die bevorzugten Ausführungsbeispiele der Erfindung werden nachstehend mit Bezug auf die Figuren im Detail beschrieben.

Jeder Aktor 2 des Stapelaktors 1 ist als Ein- oder Mehrschicht-Aktor aus Piezokeramik 2a und elektrischen Kontakten bzw. Elektrodenschichten (Innenelektroden) 2c, 2e aufgebaut. Die Piezokeramikschichten 2a sind entlang der Achse A derart gestapelt, dass zwei benachbarte Piezokeramikschichten 2a unter Zwischenschaltung jeweils eines elektrischen Kontakts (Innenelektrode) in Form einer Elektrodenschicht oder -scheibe 2c, 2e mit Polen 2b, 2d gleicher Polarität zueinander weisen.

Die elektrischen Kontakte (Innenelektroden) 2c, 2e sind wiederum mit (Außen-) Elektroden (bzw. Seitenelektroden) 25, 26 entsprechender Polarität verbunden, die umfangsseitig am Aktor 2 auf diametral entgegengesetzten Seiten des Aktors 2 beabstandet voneinander angeordnet sind. Die Anordnung der (Außen-) Elektroden (bzw. Seitenelektroden) 25, 26 in unmittelbarer Nachbarschaft zueinander kann aber auch von Vorteil sein. Im vorliegenden Beispiel ist eine Elektrodenschicht 2c als Innenelektrode an den Pluspol 2b der Piezokeramikschicht 2a angeschlossen und mit der positiven Außenelektrode 25 (in Figur 6 rechts) verbunden, während eine Elektrodenschicht 2e als Innenelektrode an den Minuspol 2d der Piezokeramikschicht 2a angeschlossen und mit der negativen Außenelektrode 26 verbunden ist.

Die Piezokeramikschichten 2a und die elektrischen Kontakte bzw. Elektrodenschichten (Innenelektroden) 2c, 2e sind unterschiedlich groß und derart aufeinandergestapelt, dass sich die Piezokeramikschichten 2a radial zur Achse A über die elektrischen Kontakte bzw. Elektrodenschichten (Innenelektroden) 2c, 2e hinaus erstrecken. Dadurch sind die elektrischen Kontakte bzw. Elektrodenschichten (Innenelektroden) 2c, 2e randseitig von piezokeramischem Material umgeben, um eine luft- und feuchtigkeitsdichte "Isolierung" zu schaffen, die den Einsatz des Aktors 2 in feuchter Umgebung ermöglicht. Die von den elektrischen Kontakten bzw. Elektrodenschichten (Innenelektroden) 2c, 2e abgedeckten und ansteuerbaren Abschnitte der Piezokeramikschichten 2a bzw. die Abschnitte, die bei Projektion auf eine senkrecht zur Achse A ausgerichtete Ebene E radial innerhalb der elektrischen Kontakte bzw. Elektrodenschicht (Innenelektroden) 2c, 2e liegen, bilden den aktiven Bereich des Aktors (in den Figuren 1 bis 3 schraffiert dargestellt), der bei elektrischer Ansteuerung verformt wird. Die von den elektrischen Kontakten bzw. Elektrodenschichten (Innenelektroden) 2c, 2e nicht abgedeckten und demnach nicht ansteuerbaren Abschnitte der Piezokeramikschichten 2a bzw. die Abschnitte, die bei Projektion auf eine senkrecht zur Achse A ausgerichtete Ebene E radial außerhalb der elektrischen Kontakte bzw. Elektrodenschicht (Innenelektroden) 2c, 2e liegen, bilden den passiven Randbereich des Aktors 2, welcher der Verformung des aktiven Bereichs passiv folgt. Umfangsseitig sind auf diametral entgegengesetzten Seiten der Umhüllung die (Außen-) Elektroden (bzw. Seitenelektroden) 25, 26 angeordnet, die zur Erleichterung einer elektrischen Kontaktierung geringfügig in radialer Richtung vorstehen.

Der in Figur 5 in perspektivischer Teilschnittansicht dargestellte Aktor 2 umfasst insgesamt 20 Piezokeramikschichten 2a, wobei 10 elektrische Kontakte (Innenelektroden) 2e an die (äußere) Minuselektrode (bzw. Seitenelektrode) 26 angeschlossen sind (in Figur 5 links im Bild) und 10 elektrische Kontakte (Innenelektroden) 2c mit der (äußeren) Pluselektrode 25 (bzw. Seitenelektrade; in Figur 5 rechts im Bild, verdeckt dargestellt) verbunden sind.

In einer bevorzugten Ausführungsform umgibt eine monolithisch versinterte keramische Isolationsschicht 20 den Aktor 2 umfangsseitig mit Ausnahme der Minuselektrode 25 und Pluselektrode 26.

Im vorliegenden Beispiel ist eine kreisförmige Kopplungsfläche K an der Oberseite 21 jedes Aktors 2 aus piezokeramischem Material ausgebildet. Die Kopplungsfläche K erstreckt sich in einer senkrecht zur Achse A stehenden Ebene E konzentrisch zur Achse A des Aktors 2 und ist axial über eine Stufe nach oben versetzt zu einem angrenzenden und umliegenden Randbereich des Aktors 2 angeordnet, um das obere axiale Ende des Aktors 2 zu bilden.

Alternativ oder zusätzlich zu der oberseitigen Kopplungsfläche K kann an der Unterseite des Aktors 2 eine entsprechende Kopplungsfläche K ausgebildet sein (vgl. Fig. 3a). Anstelle einer Stufe kann die Kopplungsfläche K auch über eine Fase in den angrenzenden oder umliegenden Bereich, insbesondere Randbereich übergehen (vgl. Fig. 3b bis 3d).

Die Kopplungsfläche K ist erfindungsgemäß kleiner als eine Projektionsfläche P des Aktors 2 auf eine senkrecht zur Achse A stehende Ebene E. Die Bedeutung dieses Merkmals wird anhand der Figuren 1 bis 4 erläutert.

Jeder Aktor 2 erzeugt bei elektrischer Ansteuerung eine Auslenkung entlang seiner Achse A. Diese Auslenkungsrichtung entspricht der Achse A, entlang derer die Piezokeramikschichten 2a übereinandergestapelt sind. Bei elektrischer Ansteuerung wird der aktive Bereich des Aktors 2 (in den Figuren 1 bis 3 schraffiert dargestellt) verformt. Der passive Bereich des Aktors 2 (in den Figuren 1 bis 3 außerhalb des schraffierten Bereichs dargestellt) verformt sich aktiv nicht, sondern folgt der Verformung des aktiven Bereichs passiv.

Im vorliegenden Beispiel liegt die Kopplungsfläche K bei Projektion auf eine senkrecht zur Stapelachse S stehende Ebene E vollständig innerhalb der Projektionsfläche P des Aktors 2 und ist vollumfänglich von der Projektionsfläche P umschlossen (sh. Fig. 4).

Im Folgenden werden zur Erläuterung des Prinzips der Erfindung mit Bezug auf die Figuren unter anderem Stapelaktoren 1 beschrieben, die aus solchen Aktoren 2 zusammengesetzt sind. Die Anzahl der Aktoren 2, die zu einem Stapelaktor 1 gekoppelt werden, ist nicht beschränkt.

Der in Figur 7 abgebildete piezoelektrische Stapelaktor 1 besteht beispielsweise aus insgesamt sechs einzelnen Aktoren 2, die für sich genommen funktionsfähig sind, um bei elektrischer Ansteuerung jeweils eine Auslenkung entlang einer Achse A zu erzeugen.

In dem in Figur 7 dargestellten Stapelaktor 1 sind die einzelnen Aktoren 2 derart gekoppelt, dass sich die bei elektrischer Ansteuerung erzeugten Auslenkungen der Aktoren 2 entlang der Stapelachse S überlagern und die Kraftkopplung der Aktoren 2 jeweils über die oberseitige Kopplungsfläche K erfolgt, die kleiner ist als eine Projektionsfläche P des Aktors 2 auf eine senkrecht zur Stapelachse S stehende Ebene E.

Die identisch ausgebildeten Aktoren 2 (vgl. Figur 5) sind mit identischer Ausrichtung bezüglich der Stapelachse S derart angeordnet, dass die Kopplungsfläche K nach oben weist und die (Außen-/Seiten-) Elektroden 25, 26 der Aktoren 2 mit gleicher Polarität in einer Linie parallel zur Stapelachse S ausgerichtet sind. Die einander zugewandten Stirnseiten benachbarter Aktoren 2 sind parallel.

Im Beispiel gemäß Figur 7 sind jeweils zwei benachbarte Aktoren 2 durch Klebstoff unter Ausbildung einer stoffschlüssigen Verbindung unmittelbar wirkverbunden und an jeweils einer Kopplungsfläche K vollständig verklebt.

Die (Außen-/Seiten-) Elektroden 25, 26 der Aktoren 2 mit derselben Polarität sind untereinander durch einen Verbindungsabschnitt 11 verbunden, wobei der Verbindungsabschnitt 11 an der entsprechenden Elektrode jedes Aktors 2 an einem einzelnen Fixierpunkt 12 befestigt ist.

In der Kopplungsebene, welche die Kopplungsfläche K einschließt, sind die Randbereiche der Aktoren 2 außerhalb der Kopplungsfläche K voneinander entkoppelt und frei zueinander beweglich. Folglich können sich Lastspitzen, die durch passive Verformungen der Piezokeramikschichten 2a bedingt sind, abbauen, ohne die Kopplung der Aktoren 2 in den Randbereichen gegenseitig zu blockieren. Dadurch wird Rissbildung vermieden und die Lebensdauer des Stapelaktors 1 erhöht sich erheblich.

Im vorliegenden Beispiel ist jede Kopplungsfläche K als Ebene ausgebildet, die sich senkrecht zur Achse A bzw. S erstreckt. Die Flächenabmessung der Kopplungsfläche K beträgt in etwa das 0,9-fache bzw. 90 % der Projektionsfläche P des Aktors 2 auf die senkrecht zur Achse A stehende Ebene.

In anderen Worten besteht der Vorteil der Erfindung, wonach die Kopplungsfläche K gegenüber der flächigen Erstreckung des Aktors 2 in einer Ebene senkrecht zur Achse A verkleinert ist, sinngemäß darin, dass die benachbarten Aktoren 2 in den durch passive Isolationsränder gebildeten Randbereichen gezielt voneinander entkoppelt sind. In jedem Aktor 2 kommt es bei Ausdehnung zu Zugspannungen im sog. passiven Bereich, weil dieser keine Elektroden 2b enthält und sich demnach nicht aktiv verformt. Aufgrund der geringen Höhe der Aktoren 2 und einer passiven Deformation der Randbereiche liegt die Zugspannung bei jedem einzelnen Aktor 2 unterhalb einer kritischen Belastung. Bei vollflächiger Verklebung der Aktoren 2 über deren gesamte Querschnittsfläche (Erstreckung in einer Ebene senkrecht zur Achse A) würde die Kopplung der Aktoren diese Deformation blockieren und verhindern. Der Effekt verstärkt sich umso weiter, je mehr Aktoren 2 übereinander geklebt werden. Die durch die Deformation entstehenden Spannungen würden sich ohne Gegenmaßnahmen addieren und die letztendlich Festigkeit der passiven Randschicht überschreiten. An den schwächsten Stellen käme es ohne die erfindungsgemäßen Merkmale zur Rissbildung.

Ein Spannungsabbau durch die Klebstoffschichten ist i.d.R. nicht ausreichend, da zum Erreichen hoher Aktorsteifigkeiten steife Kleber und sehr dünne Klebespalte Verwendung finden. Gleichwohl liegt es im Rahmen der Erfindung, dass auch weiche und dämpfende Klebstoffe verwendet werden können.

Die Verklebung findet daher vorzugsweise nur an den Kopplungsflächen K statt und nicht in den Randbereichen der Aktoren 2, welche die Kopplungsflächen K in den Kopplungsebenen umgeben. Die Kopplungsflächen K sind kleiner als die flächige Erstreckung der zu koppelnden Aktoren 2 in einer Ebene E senkrecht zur Stapelachse S bzw. kleiner als die Projektionsflächen P der zu koppelnden Aktoren 2 auf eine senkrecht zur Achse A bzw. S stehende Ebene E (vgl. Fig. 4). Da die Verformung der Aktoren 2 exakt entlang dieser Achse A bzw. S erfolgt, ist für die Deformation der passiven Bereiche der Aktoren 2 somit eine entsprechende Möglichkeit zum Abbau von Lastspitzen geschaffen.

Zur Umsetzung des Erfindungsgegenstands sind verschiedene Ausführungsvarianten denkbar.

Einerseits ist es möglich, den Klebstoff im Randbereich auszusparen. Technisch ist dies anspruchsvoll, da der Klebstoff während der Aushärtung unter Druck und meist auch erhöhter Temperatur fließt. Eine definierte und reproduzierbare Klebung auf einer unbegrenzten Fläche innerhalb einer Ebene ist damit schwer möglich. Daher ist die Kopplungsfläche K zu den angrenzenden Flächen vorzugsweise versetzt angeordnet oder begrenzt.

Vorzugsweise wird daher ein Trennmittel im Bereich des Isolationsrandes aufgetragen, das die die Kopplungsfläche K begrenzt, indem es entweder den Kontakt mit dem Klebstoff oder zumindest dessen Haftung an mindestens einem Verbindungspartner verhindert.

Alternativ kann ein dünnes Zusatzelement 3 mit geringerem Querschnitt zwischen je zwei Aktoren 2 eingebracht werden, wobei das Zusatzelement 3 die Kopplungsflächen K zu den angrenzenden Aktoren 2 bildet (Figur 1 oder Figur 6). Beispielsweise könnten dünne Metallplättchen mit umlaufend kleineren Abmessungen als die Aktoren 2 (mind. so viel kleiner, wie der Isolationsrand breit ist) zwischen die Aktoren 2 geklebt werden. Somit bleibt der Isolationsrand frei und kann sich verformen wie bei einem einzelnen Aktor 2.

Die Ausarbeitung einer kleinen Stufe an den axialen Stirnseiten der einzelnen Aktoren 2 ist ebenfalls möglich (Fig. 3a). Die Stufe ist in etwa so breit wie der Isolationsrand und einige 10 µm hoch. Sie führt zum selben Resultat wie das Einfügen eines zusätzlichen dünnen Zusatzelements 3 (Figur 1 oder Figur 6), vereinfacht jedoch die Montage und Positionierung und reduziert die Anzahl an Klebefugen. Die Stufe kann sowohl nur einseitig (nicht dargestellt) als auch beidseitig vorgesehen werden (Figur 3a). Bei einseitiger Ausführung reduziert sich der Fertigungsaufwand, bei beidseitiger Ausführung kann der Abtrag je Seite reduziert werden, wodurch sich die erforderliche Dicke der passiven Endschichten reduziert.

Anstelle der Stufe kann auch eine Fase oder eine andere Aussparung verwendet werden (Figuren 3a bis 3d). Weiterhin ist die Verwendung von Aktoren 2 mit gewölbter Oberfläche möglich.

Bei Hochvoltaktoren wird standardmäßig ein dünnes Blech mit reduziertem Querschnitt zwischen die Aktorsegmente geklebt (Figur 6). Dieses dient gleichzeitig sowohl als Elektrode 2b, 2d zur späteren Kontaktierung der Außenelektroden 25, 26 sowie der Elektroden an der Oberfläche der Stapel, als auch als Zusatzelement 3, indem es die Kopplungsfläche zwischen den Aktoren 2 gegenüber der flächenmäßigen Erstreckung der Aktoren 2 in einer senkrecht zur Achse A, S ausgerichteten Ebene verringert. Die Aktoren 2 werden jedoch zum Schutz vor äußeren Einflüssen mit einem Kleber überzogen, wodurch die verbliebenen Abstände im Randbereich der Aktoren 2 mit Kleber gefüllt werden.

Ein Lösungsansatz für diesen Aktortyp ist die Aufbringung einer Schutzschicht, die die Abstände nicht vollständig füllt. Dies ist zum einen durch das Aufbringen einer sehr dünnen Schicht möglich (z.B. durch Aufdampfen, Sprühen, ...). Weiterhin ist das Aufbringen eines Filmes anstatt einer Flüssigkeit möglich.

Eine weitere Alternative ist das Füllen der Abstände mit einem nachgiebigen Material. Im Anschluss kann dann der Stapel wie üblich umhüllt werden.

Für beide Arten von Aktoren 2 sind die genannten Lösungsansätze für beliebige Querschnitte in Bezug auf Form (rund, oval, rechteckig, ...) und Größe anwendbar. Hierbei sind nicht nur Vollquerschnitte denkbar, sondern auch Hohlquerschnitte, beispielsweise in Form von Hohlzylindern.

Tests an verschiedenen Aktoren 2 haben ergeben, dass die Lebensdauer bei statischer Spannung einzelner Chipaktoren i.d.R. wesentlich höher ist als die von geklebten Chipstapeln, ggf. sogar um mindestens Faktor 2.

Durch die erfindungsgemäße Entkopplung der kritischen Bereiche der Chips bleibt der Vorteil in Bezug auf die Lebensdauer im geklebten Stapel erhalten.

Bei Aktoren 2, die einen kreisrunden Querschnitt in einer Ebene senkrecht zur Stapelachse S aufweisen, kann das Verhältnis von Durchmesser D zur Höhe H spezifiziert werden. In einer vorteilhaften Weiterbildung der oben beschriebenen Ausführungsformen ist das Verhältnis D/H ≥ 1, vorzugsweise ist D/H > 5 und besonders bevorzugt ist D/H = 6,4. Weiterhin kann es sinnvoll sein, wenn DIH < 50 ist.

Bei Aktoren 2, die einen rechteckigem Querschnitt in einer Ebene senkrecht zur Stapelachse S aufweisen, kann das Verhältnis von Kantenlänge L zur Höhe H spezifiziert werden. In einer vorteilhaften Weiterbildung, die Aktoren 2 mit rechteckigem Querschnitt betrifft, ist das Verhältnis L/H ≥ 1, vorzugsweise ist L/H > 5 und besonders bevorzugt ist L/H = 6,4. Weiterhin kann es sinnvoll sein, wenn LIH < 50 ist.

Mit derartigen D/H bzw. UH-Verhältnisse gelingt es, Aktoren mit hoher Steifigkeit und gleichzeitig hoher Auslenkung bereitzustellen, die dabei eine minimale Rissneigung und folglich eine hohe Zuverlässigkeit aufweisen.

Bei Aktoren 2 mit kreisrundem Querschnitt ergibt sich gegenüber Aktoren 2 mit rechteckigem Querschnitt generell der Vorteil, dass eine gleichmäßigere Verformung im Übergangsbereich zwischen aktivem und passivem Bereich stattfindet, da der passive Bereich einen konstanten radialen Abstand von der Stapelachse S aufweist, was bei quadratischen oder rechteckigen Aktorquerschnitten nicht der Fall ist.

### Bezugszeichenliste

- 1: Stapelaktor
- 2: Aktor
- 2a: Piezokeramikschicht
- 2b: Pluspol
- 2c: Kontakt(blech) bzw. (Innen-)Elektrode für Pluspol
- 2d: Minuspol
- 2e: Kontakt(blech) bzw. (Innen-)Elektrode für Minuspol
- 3: Zusatzelement
- 20: Isolierung
- 21: Oberseite
- 22: Unterseite
- 23: Stufe/Fase an der Oberseite
- 24: Stufe/Fase an der Unterseite
- 25: (Außen-/Seiten-) Elektrode Pluspol
- 26: (Außen-/Seiten-) Elektrode Minuspol
- A: Achse
- D: Durchmesser eines Aktors mit kreisrundem Querschnitt
- E: Ebene senkrecht zur Stapelachse
- H: Höhe eines Aktors
- K: Kopplungsfläche
- L: Kantenlänge eines Aktors mit rechteckigem Querschnitt
- P: Projektionsfläche auf Ebene senkrecht zur Achse
- S: Stapelachse

## Patentansprüche

1. Verfahren zur Herstellung eines piezoelektrischen Stapelaktors (1), umfassend die Schritte:
a. Schritt A: Bereitstellen von wenigstens zwei Aktoren (2), die ausgebildet sind, um bei elektrischer Ansteuerung jeweils eine Auslenkung entlang einer Achse (A) zu erzeugen, wobei Schritt A folgende Teilschritte umfasst:
Teilschritt A1: Bereitstellen von Piezokeramikschichten (2a) und elektrischen Kontakten (2c, 2e) zum Aufbau der Aktoren (2) als Mehrschichtaktoren, und
Teilschritt A4: Umhüllen der Piezokeramikschichten (2a) und der elektrischen Kontakte (2c, 2e) mit keramischem Isolierstoff (20).
b. Schritt B: Koppeln der wenigstens zwei Aktoren (2) zur Ausbildung des Stapelaktors (1), sodass sich die bei elektrischer Ansteuerung erzeugten Auslenkungen der Aktoren (2) entlang einer Stapelachse (S) überlagern und eine Kraftkopplung der Aktoren (2) über mindestens eine Kopplungsfläche (K) erfolgt, die kleiner ist als eine Projektionsfläche (P) des Aktors (2) auf eine senkrecht zur Stapelachse (S) stehende Ebene (E).

2. Verfahren nach Anspruch 1, **dadurch gekennzeichnet, dass** Schritt A wenigstens einen der folgenden Teilschritte aufweist:
a. Teilschritt A2: Stapeln der Piezokeramikschichten (2a) entlang einer Achse (A), vorzugsweise derart, dass zwei benachbarte Piezokeramikschichten (2a) unter Zwischenschaltung jeweils eines elektrischen Kontakts (2c, 2e), bevorzugt einer Elektrodenschicht oder eines Kontaktblechs, mit Polen (2b, 2d) gleicher Polarität zueinander weisen.
b. Teilschritt A3: Verbinden der elektrischen Kontakte (2c, 2e) mit Elektroden (25, 26) entsprechender Polarität, wobei die Elektroden (25, 26) unterschiedlicher Polarität vorzugsweise umfangsseitig am Aktor (2) beabstandet voneinander angeordnet sind, bevorzugt sich auf diametral entgegengesetzten Seiten des Aktors (2) befinden.
c. Teilschritt A4-1: Umhüllen der Piezokeramikschichten (2a) und der elektrischen Kontakte (2c, 2e) mit monolithisch versintertem keramischen Isolierstoff (20), wobei die Umhüllung mit Isolierstoff (20) besonders bevorzugt luftdicht und/oder feuchtigkeitsdicht ist.
d. Teilschritt A5: Ausbilden mindestens einer Kopplungsfläche (K) zur Kraftkopplung des Aktors (2) mit einem benachbarten Aktor (2), vorzugsweise nach wenigstens einem der folgenden Teilschritte:
i. Teilschritt A5-1: Ausbilden wenigstens einer Kopplungsfläche (K) an der Umhüllung des Aktors (2), besonders bevorzugt unter Beibehaltung der Isolierfunktion der Umhüllung.
ii. Teilschritt A5-2: Ausbilden wenigstens einer Kopplungsfläche (K) an einem zwischen zwei zu koppelnden Aktoren (2) anzuordnenden Zusatzelement (3), wobei das Zusatzelement (3) vorzugsweise als Elektrode ausgebildet ist.
iii. Teilschritt A5-3: Ausbilden der Kopplungsfläche (K) an einem oder beiden axialen Ende(n) des Aktors (2) bzw. des Zusatzelements (3), vorzugsweise derart, dass die Kopplungsfläche (K) eines der oder beide axialen Enden des Aktors (2) bzw. des Zusatzelements (3) bildet.
iv. Teilschritt A5-7: Ausbilden der Kopplungsfläche (K), sodass in Bezug auf die Projektionsfläche (P) des Aktors (2) folgendes Flächenverhältnis gilt: 0,7*P ≤ K < P, vorzugsweise 0,8*P ≤ K ≤ 0,99*P, bevorzugt 0,9*P ≤ K ≤ 0,95*P.

3. Verfahren nach einem der vorangehenden Ansprüche, **dadurch gekennzeichnet, dass** Schritt B wenigstens einen der folgenden Teilschritte aufweist:
a. Teilschritt B2: Anordnen eines vorzugsweise als Elektrode ausgebildeten Zusatzelements (3) zwischen zwei benachbarten Aktoren (2).
b. Teilschritt B3: Verbinden der wenigstens zwei Aktoren (2), sodass jeweils zwei benachbarte Aktoren (2) unmittelbar wirkverbunden oder mittelbar über ein Zusatzelement (3) wirkverbunden sind, vorzugsweise unter Ausbildung einer stoffschlüssigen Verbindung zwischen den benachbarten Aktoren (2) oder zwischen jedem der benachbarten Aktoren (2) und dem dazwischen angeordneten Zusatzelement (3), bevorzugt durch Klebstoff, wobei besonders bevorzugt der Klebstoff die mindestens eine Kopplungsfläche (K) vollständig verklebt.
c. Teilschritt B4: Entkoppeln zweier Aktoren (2) außerhalb der mindestens einen Kopplungsfläche (K), vorzugsweise im Randbereich, bevorzugt in der Kopplungsebene, besonders bevorzugt durch Entfernen von piezokeramischem Material und/oder von Klebstoff und/oder Auftragen von Trennmittel.
d. Teilschritt B5: Verbinden der Elektroden (25, 26) der Aktoren (2) mit derselben Polarität untereinander durch einen Verbindungsabschnitt (11), vorzugsweise durch Aufbringen des Verbindungsabschnitts (11) auf die Elektroden (25, 26).

4. Piezoelektrischer Stapelaktor (1), vorzugsweise hergestellt nach dem Verfahren gemäß einem der vorangehenden Ansprüche, umfassend wenigstens zwei Aktoren (2), die aus Piezokeramikschichten (2a) und elektrischen Kontakten (2c, 2e) jeweils als Mehrschichtaktoren aufgebaut sind und ausgebildet sind, um bei elektrischer Ansteuerung jeweils eine Auslenkung entlang einer Achse (A) zu erzeugen, wobei die wenigstens zwei Aktoren (2) entlang einer Stapelachse (S) derart gestapelt sind, sodass sich die bei elektrischer Ansteuerung erzeugten Auslenkungen der Aktoren (2) entlang der Stapelachse (S) überlagern, wobei die wenigstens zwei Aktoren (2) derart gekoppelt sind, dass eine Kopplungsfläche (K), über welche eine Kraftkopplung eines Aktors (2) zu einem benachbarten Aktor (2) erfolgt, kleiner ist als eine Projektionsfläche (P) des Aktors (2) auf eine senkrecht zur Achse (A) stehende Ebene, **dadurch gekennzeichnet, dass** die Piezokeramikschichten (2a) und die elektrischen Kontakte (2c,2e) mit einem keramischen Isolierstoff (20) umhüllt sind.

5. Piezoelektrischer Stapelaktor (1) nach Anspruch 4, **dadurch gekennzeichnet, dass** jeder der Aktoren (2) wenigstens eines der folgenden Merkmale aufweist:
a. Die Piezokeramikschichten (2a) sind entlang einer Achse (A) gestapelt, vorzugsweise derart, dass zwei benachbarte Piezokeramikschichten (2a) unter Zwischenschaltung jeweils eines elektrischen Kontakts (2c, 2e), bevorzugt einer Elektrodenschicht oder eines Kontaktblechs, mit Polen (2b, 2d) gleicher Polarität zueinander weisen.
b. Die elektrischen Kontakte (2c, 2e) sind mit Elektroden (25, 26) entsprechender Polarität verbunden, wobei die Elektroden (25, 26) unterschiedlicher Polarität vorzugsweise umfangsseitig am Aktor (2) beabstandet voneinander angeordnet sind, bevorzugt sich auf diametral entgegengesetzten Seiten des Aktors (2) befinden.
c. Die Piezokeramikschichten (2a) und die elektrischen Kontakte (2c, 2e) sind mit monolithisch versintertem keramischen Isolierstoff (20), umhüllt, wobei die Umhüllung mit Isolierstoff (20) besonders bevorzugt luftdicht und/oder feuchtigkeitsdicht ist.
d. Der Aktor weist in einer Ebene senkrecht zur Stapelachse S eine im Wesentlichen oder näherungsweise kreisrunde Querschnittsform auf.
e. Der Aktor weist in einer Ebene senkrecht zur Stapelachse S einen Vollquerschnitt oder Hohlquerschnitt auf.
f. Bei Aktoren (2) mit kreisrundem Querschnitt ist das Verhältnis von Durchmesser zu Höhe D/H ≥ 1, vorzugsweise ist D/H > 5 und besonders bevorzugt ist D/H = 6,4.
g. Bei Aktoren (2) mit rechteckigem Querschnitt ist das Verhältnis von Kantenlänge zu Höhe L/H ≥ 1, vorzugsweise ist L/H > 5 und besonders bevorzugt ist L/H = 6,4.

6. Piezoelektrischer Stapelaktor (1) nach einem der Ansprüche 4 bis 5, **dadurch gekennzeichnet, dass** die Kopplungsfläche (K) wenigstens eines der folgenden Merkmale aufweist:
a. Die wenigstens eine Kopplungsfläche (K) ist an der Umhüllung des Aktors (2), besonders bevorzugt unter Beibehaltung der Isolierfunktion der Umhüllung.
b. Die wenigstens eine Kopplungsfläche (K) ist an einem zwischen zwei zu koppelnden Aktoren (2) anzuordnenden Zusatzelement (3) ausgebildet, wobei das Zusatzelement (3) vorzugsweise als Elektrode ausgebildet ist.
c. Die wenigstens eine Kopplungsfläche (K) ist an einem oder beiden axialen Ende(n) des Aktors (2) bzw. des Zusatzelements (3) ausgebildet, vorzugsweise derart, dass die Kopplungsfläche (K) eines der oder beide axialen Enden des Aktors (2) bzw. des Zusatzelements (3) bildet.
d. Die wenigstens eine Kopplungsfläche (K) ist derart ausgebildet, dass in Bezug auf die Projektionsfläche (P) des Aktors (2) folgendes Flächenverhältnis gilt: 0,1*P < K < P, vorzugsweise 0,5*P < K < 0,95*P, bevorzugt 0,75*P < K < 0,9*P.

7. Piezoelektrischer Stapelaktor (1) nach einem der Ansprüche 4 bis 6, **dadurch gekennzeichnet, dass** der Stapelaktor (1) wenigstens eines der folgenden Merkmale aufweist:
a. Wenigstens ein Zusatzelement (3) ist zwischen zwei benachbarten Aktoren (2) angeordnet, wobei das Zusatzelement (3) vorzugsweise als Elektrode ausgebildet ist.
b. Wenigstens zwei benachbarte Aktoren (2) sind unmittelbar wirkverbunden oder mittelbar über ein Zusatzelement (3) wirkverbunden, vorzugsweise durch eine stoffschlüssige Verbindung zwischen den benachbarten Aktoren (2) oder zwischen jedem der benachbarten Aktoren (2) und dem dazwischen angeordneten Zusatzelement (3), bevorzugt durch Klebstoff, wobei besonders bevorzugt der Klebstoff die mindestens eine Kopplungsfläche (K) vollständig verklebt.
c. Wenigstens zwei benachbarte Aktoren (2) sind mit Ausnahme der mindestens einen Kopplungsfläche (K) voneinander entkoppelt, vorzugsweise im Randbereich, bevorzugt in der Kopplungsebene, besonders bevorzugt durch Entfernen von piezokeramischem Material und/oder von Klebstoff und/oder durch Auftragen von Trennmittel vor dem Verkleben.
d. Die Elektroden (25, 26) der Aktoren (2) mit derselben Polarität sind untereinander durch einen Verbindungsabschnitt (11) verbunden, wobei der Verbindungsanschnitt vorzugsweise auf die Elektroden (25, 26) aufgebracht ist.

## Claims

1. Method for producing a piezoelectric stack actuator (1), comprising the steps of:
a. Step A: Providing at least two actuators (2) which are designed to generate a deflection along an axis (A) when electrically activated, wherein step A comprises the following sub-steps:
Sub-step A1: Providing piezoceramic layers (2a) and electric contacts (2c, 2e) to make up the actuators (2) as multi-layer actuators, and
Sub-step A4: Enveloping the piezoceramic layers (2a) and the electric contacts (2c, 2e) with a ceramic insulating material (20).
b. Step B: Coupling the at least two actuators (2) to form the stack actuator (1) such that the deflections of the actuators (2) generated when the actuators are electrically activated are overlaid along a stacking axis (S) and there is a force-coupling of the actuators (2) over at least one coupling area (K) that is smaller than a projection area (P) of the actuator (2) onto a plane (E) perpendicular to the stacking axis (S).

2. Method according to claim 1, **characterized in that** step A comprises at least one of the following sub-steps:
a. Sub-step A2: Stacking the piezoceramic layers (2a) along an axis (A), preferably such that two adjacent piezoceramic layers (2a) face each other with the insertion of one electric contact (2c, 2e) each, preferably an electrode layer or a contact plate, with poles (2b, 2d) of the same polarities.
b. Sub-step A3: Connecting the electric contacts (2c, 2e) with electrodes (25, 26) of corresponding polarities, wherein the electrodes (25, 26) of different polarities are preferably arranged spaced apart at the periphery of the actuator (2), preferably located on diametrically opposed sides of the actuator (2).
c. Sub-step A4-1: Enveloping the piezoceramic layers (2a) and the electric contacts (2c, 2e) with a monolithically sintered ceramic insulating material (20), wherein the envelope with the insulating material (20) is particularly preferred air-tight and/or moisture-tight.
d. Sub-step A5: Forming at least one coupling area (K) for force-coupling the actuator (2) with an adjacent actuator (2), preferably according to at least one of the following sub-steps:
i. Sub-step A5-1: Forming at least one coupling area (K) at the envelope of the actuator (2), particularly preferred while maintaining the insulating function of the envelope.
ii. Sub-step A5-2: Forming at least one coupling area (K) at an additional element (3) to be arranged between two actuators (2) to be coupled, wherein the additional element (3) is preferably embodied as an electrode.
iii. Sub-step A5-3: Forming the coupling area (K) at one or both axial end(s) of the actuator (2) or the additional element (3), respectively, preferably such that the coupling area (K) forms one of the or both axial ends of the actuator (2) or the additional element (3), respectively.
iv. Sub-step A5-7: Forming the coupling area (K) such that with respect to the projection area (P) of the actuator (2), the following area ratio applies: 0.7*P ≤ K < P, preferably 0.8*P ≤ K ≤ 0.99*P, preferably 0.9*P ≤ K ≤ 0.95*P.

3. Method according to one of the preceding claims, **characterized in that** step B comprises at least one of the following sub-steps:
a. Sub-step B2: Arranging an additional element (3), preferably embodied as an electrode, between two adjacent actuators (2).
b. Sub-step B3: Connecting the at least two actuators (2) such that two adjacent actuators (2) each are directly actively connected or indirectly actively connected via an additional element (3), preferably while forming a firmly bonded connection between the adjacent actuators (2) or between each one of the adjacent actuators (2) and the additional element (3) arranged therebetween, preferably by an adhesive, wherein particularly preferably the adhesive glues the at least one coupling area (K) completely.
c. Sub-step B4: Decoupling two actuators (2) outside the at least one coupling area (K), preferably in the edge region, preferably in the coupling plane, particularly preferred by removing piezoceramic material and/or adhesive and/or by applying release agents.
d. Sub-step B5: Connecting the electrodes (25, 26) of the actuators (2) with the same polarities to each other by a connecting section (11), preferably by applying the connecting section (11) onto the electrodes (25, 26).

4. Piezoelectric stack actuator (1), preferably produced according to the method according to one of the preceding claims, comprising at least two actuators (2) which are made up of piezoceramic layers (2a) and electric contacts (2c, 2e) each as multi-layer actuators and designed to generate a deflection along an axis (A) when electrically activated, wherein the at least two actuators (2) are stacked along a stacking axis (S) such that the deflections of the actuators (2) generated when the actuators are electrically activated are overlaid along the stacking axis (S), wherein the at least two actuators (2) are coupled such that a coupling area (K) over which a force-coupling of an actuator (2) to an adjacent actuator (2) is effected, is smaller than a projection area (P) of the actuator (2) onto a plane perpendicular to the axis (A), **characterized in that** the piezoceramic layers (2a) and the electric contacts (2c, 2e) are enveloped with a ceramic insulation material (20).

5. Piezoelectric stack actuator (1) according to claim 4, **characterized in that** each one of the actuators (2) has at least one of the following features:
a. The piezoceramic layers (2a) are stacked along an axis (A), preferably such that two adjacent piezoceramic layers (2a) face each other with the insertion of one electric contact (2c, 2e) each, preferably an electrode layer or a contact plate, with poles (2b, 2d) of the same polarities.
b. The electric contacts (2c, 2e) are connected with electrodes (25, 26) of corresponding polarities, wherein the electrodes (25, 26) of different polarities are preferably arranged spaced apart at the periphery of the actuator (2) and are preferably located on diametrically opposed sides of the actuator (2).
c. The piezoceramic layers (2a) and the electric contacts (2c, 2e) are enveloped with a monolithically sintered ceramic insulating material (20), wherein the envelope with the insulating material (20) is particularly preferred air-tight and/or moisture-tight.
d. The actuator has, in a plane perpendicular to the stacking axis S, an essentially or approximately circular cross-sectional shape.
e. The actuator has, in a plane perpendicular to the stacking axis S, a full cross-section or a hollow cross-section.
f. With actuators (2) with a circular cross-section, the ratio of the diameter to the height is D/H ≥ 1, preferably D/H > 5, and particularly preferred D/H = 6.4.
g. With actuators (2) with a rectangular cross-section, the ratio of the edge length to the height is L/H ≥ 1, preferably L/H > 5, and particularly preferred L/H = 6.4.

6. Piezoelectric stack actuator (1) according to one of claims 4 to 5, **characterized in that** the coupling area (K) has at least one of the following features:
a. The at least one coupling area (K) is at the envelope of the actuator (2), preferably while maintaining the insulating function of the envelope.
b. The at least one coupling area (K) is formed at an additional element (3) to be arranged between two actuators (2) to be coupled, wherein the additional element (3) is preferably embodied as an electrode.
c. The at least one coupling area (K) is formed at one or both axial end(s) of the actuator (2) or the additional element (3), respectively, preferably such that the coupling area (K) forms one of or both axial ends of the actuator (2) or the additional element (3), respectively.
d. The at least one coupling area (K) is designed such that with respect to the projection area (P) of the actuator (2), the following area ratio applies: 0.1*P < K < P, preferably 0.5*P < K < 0.95*P, preferably 0.75*P < K < 0.9*P.

7. Piezoelectric stack actuator (1) according to one of claims 4 to 6, **characterized in that** the stack actuator (1) has at least one of the following features:
a. At least one additional element (3) is arranged between two adjacent actuators (2), wherein the additional element (3) is preferably embodied as an electrode.
b. At least two adjacent actuators (2) are directly actively connected or indirectly actively connected via an additional element (3), preferably by a firmly bonded connection between the adjacent actuators (2) or between each one of the adjacent actuators (2) and the additional element (3) arranged therebetween, preferably by an adhesive, wherein particularly preferably the adhesive glues the at least one coupling area (K) completely.
c. At least two adjacent actuators (2) are decoupled from each other, except for the at least one coupling area (K), preferably in the edge region, preferably in the coupling plane, particularly preferred by removing piezoceramic material and/or adhesive and/or by applying release agents before gluing.
d. The electrodes (25, 26) of the actuators (2) with the same polarities are connected to each other by a connecting section (11), wherein the connecting section is preferably applied onto the electrodes (25, 26).

## Revendications

1. Procédé de fabrication d'un actionneur à empilement piézoélectrique (1), comprenant les étapes consistant à :
a. étape A : mettre à disposition au moins deux actionneurs (2) qui sont conçus pour générer, lors d'une commande électrique, à chaque fois une déviation le long d'un axe (A), dans lequel l'étape A comprend les sous-étapes suivantes :
sous-étape A1 : mise à disposition de couches piézo-céramiques (2a) et de contacts électriques (2c, 2e) pour la construction des actionneurs (2) sous la forme d"actionneurs multicouches, et
sous-étape A4 : enveloppement des couches piézo-céramiques (2a) et des contacts électriques (2c, 2e) avec un isolant de céramique (20).
b. étape B : coupler les au moins deux actionneurs (2) pour former l'actionneur à empilement (1), de telle sorte que les déviations, générées lors d'une commande électrique, des actionneurs (2) le long d'un axe d'empilement (S) se chevauchent et qu'un couplage à force des actionneurs (2) se produit via au moins une surface de couplage (K), qui est plus petite qu'une surface de projection (P) de l'actionneur (2) sur un plan (E) perpendiculaire à l'axe d'empilement (S).

2. Procédé selon la revendication 1, dans lequel l'étape A comprend au moins une des sous-étapes ci-dessous :
a. sous-étape A2 : empilement des couches piézo-céramiques (2a) le long d'un axe (A), de préférence de telle sorte que deux couches piézo-céramiques (2a) voisines, avec interposition d'un contact électrique respectif (2c, 2e), de préférence d'une couche d'électrode ou d'une tôle de contact, présentent des pôles (2b, 2d) de même polarité l'un par rapport à l'autre.
b. sous-étape A3 : connexion des contacts électriques (2c, 2e) à des électrodes (25, 26) de polarité correspondante, dans lequel les électrodes (25, 26) de polarité différente sont de préférence disposées à distance l'une de l'autre sur le côté périphérique de l'actionneur (2), de préférence sur des côtés diamétralement opposés de l'actionneur (2).
c. sous-étape A4-1 : enveloppement des couches piézo-céramiques (2a) et des contacts électriques (2c, 2e) avec un matériau isolant de céramique (20) fritté de manière monolithique, dans lequel l'enveloppement avec le matériau isolant (20) est de préférence étanche à l'air et/ou à l'humidité.
d. sous-étape A5 : formation d'au moins une surface de couplage (K) pour un couplage à force de l'actionneur (2) avec un actionneur (2) voisin, de préférence après au moins l'une des sous-étapes suivantes :
i. sous-étape A5-1 : formation d'au moins une surface de couplage (K) sur l'enveloppe de l'actionneur (2), de manière particulièrement préférée en maintenant la fonction isolante de l'enveloppe.
ii. sous-étape A5-2 : formation d'au moins une surface de couplage (K) sur un élément supplémentaire (3) à placer entre deux actionneurs (2) à coupler, dans lequel l'élément supplémentaire (3) est de préférence réalisé sous la forme d'une électrode.
iii. sous-étape A5-3 : formation de la surface de couplage (K) au niveau d'une ou des deux extrémités axiales de l'actionneur (2) ou de l'élément supplémentaire (3), de préférence de telle manière que la surface de couplage (K) forme une ou les deux extrémités axiales de l'actionneur (2) ou de l'élément supplémentaire (3).
iv. sous-étape A5-7 : formation de la surface de couplage (K) de sorte que, par rapport à la surface de projection (P) de l'actionneur (2), le rapport de surface suivant s'applique : 0,7*P ≤ K < P, de préférence 0,8*P ≤ K ≤ 0,99*P, de préférence 0,9*P ≤ K ≤ 0,95*P.

3. Procédé selon l'une quelconque des revendications précédentes, **caractérisé en ce que** l'étape B comprend au moins l'une des sous-étapes ci-dessous :
a. sous-étape B2 : agencement d'un élément supplémentaire (3) réalisé de préférence sous la forme d'une électrode entre deux actionneurs (2) voisins.
b. sous-étape B3 : connexion des au moins deux actionneurs (2), de sorte que deux actionneurs (2) voisins sont connectés directement ou indirectement par l'intermédiaire d'un élément supplémentaire (3), de préférence en formant une liaison par complémentarité de matière entre les actionneurs (2) voisins ou entre chacun des actionneurs (2) voisins et l'élément supplémentaire (3) disposé entre eux, de préférence au moyen d'un adhésif, dans lequel l'adhésif colle de manière particulièrement préférée la au moins une surface de couplage (K).
c. sous-étape B4 : découplage de deux actionneurs (2) à l'extérieur de la au moins une surface de couplage (K), de préférence dans la zone de bord, de préférence dans le plan de couplage, de manière particulièrement préférée par élimination de matériau de piézo-céramique et/ou d'adhésif et/ou application d'agents de démoulage.
d. sous-étape B5 : connexion des électrodes (25, 26) des actionneurs (2) avec la même polarité entre elles par une partie de connexion (11), de préférence par application de la partie de connexion (11) sur les électrodes (25, 26).

4. Actionneur à empilement piézoélectrique (1), de préférence fabriqué par le procédé selon l'une quelconque des revendications précédentes, comprenant au moins deux actionneurs (2), qui sont chacun réalisés sous la forme d'actionneurs multicouches à partir de couches piézo-céramiques (2a) et de contacts électriques (2c, 2e), et sont conçus pour une commande électrique afin de générer une déviation le long d'un axe (A), dans lequel les au moins deux actionneurs (2) sont empilés le long d'un axe d'empilement (S) de telle sorte que les déviations des actionneurs (2), générées par la commande électrique, le long de l'axe d'empilement (S) se chevauchent, dans lequel les au moins deux actionneurs (2) sont couplés de telle sorte qu'une surface de couplage (K) via laquelle un couplage à force d'un actionneur (2) à un actionneur adjacent (2) a lieu est plus petite qu'une surface de projection (P) de l'actionneur (2) sur un plan perpendiculaire à l'axe (A), **caractérisé en ce que** les couches piézo-céramiques (2a) et les contacts électriques (2c, 2e) sont enveloppés d'un matériau isolant de céramique (20).

5. Actionneur à empilement piézoélectrique (1) selon la revendication 4, **caractérisé en ce que** chacun des actionneurs (2) présente au moins l'une des caractéristiques suivantes :
a. les couches piézo-céramiques (2a) sont empilées le long d'un axe (A), de préférence de telle sorte que deux couches piézo-céramiques voisines (2a) présentent entre elles des pôles (2b, 2d) de même polarité, avec interposition d'un contact électrique respectif (2c, 2e), de préférence d'une couche d'électrode ou d'une tôle de contact.
b. les contacts électriques (2c, 2e) sont connectés à des électrodes (25, 26) de polarité correspondante, dans lequel les électrodes (25, 26) de polarité différente sont disposées de préférence à distance l'une de l'autre sur le côté périphérique de l'actionneur (2), de préférence sur des côtés diamétralement opposés de l'actionneur (2).
c. les couches piézo-céramiques (2a) et les contacts électriques (2c, 2e) sont revêtus d'un matériau isolant de céramique (20) fritté de manière monolithique, dans lequel l'enveloppe de matériau isolant (20) est de préférence étanche à l'air et/ou à l'humidité.
d. l'actionneur présente une forme de section transversale essentiellement ou approximativement circulaire dans un plan perpendiculaire à l'axe d'empilement S.
e. l'actionneur présente une section transversale pleine ou une section transversale creuse dans un plan perpendiculaire à l'axe d'empilement S.
f. pour les actionneurs (2) de section transversale circulaire, le rapport diamètre/hauteur D/H est ≥ 1, de préférence D/H > 5, et de manière particulièrement préférée D/H = 6,4.
g. pour les actionneurs (2) de section transversale rectangulaire, le rapport entre la longueur de bord et la hauteur est L/H ≥ 1, de préférence L/H > 5, et de manière particulièrement préférée UH = 6,4.

6. Actionneur à empilement piézoélectrique(1) selon l'une quelconque des revendications 4 à 5, **caractérisé en ce que** la surface de couplage (K) présente au moins l'une des caractéristiques suivantes :
a. la au moins une surface de couplage (K) se trouve sur l'enveloppe de l'actionneur (2), de préférence en maintenant la fonction isolante de l'enveloppe.
b. la au moins une surface de couplage (K) est réalisée sur un élément supplémentaire (3) à placer entre deux actionneurs (2) à coupler, dans lequel l'élément supplémentaire (3) est de préférence réalisé sous la forme d'une électrode.
c. la au moins une surface de couplage (K) est formée sur une ou les deux extrémités axiales de l'actionneur (2) ou de l'élément supplémentaire (3), de préférence de telle manière que la surface de couplage (K) forme l'une ou les deux extrémités axiales de l'actionneur (2) ou de l'élément supplémentaire (3).
d. la au moins une surface de couplage (K) est formée de telle sorte que, par rapport à la surface de projection (P) de l'actionneur (2), le rapport de surface suivant s'applique : 0,1 *P < K < P, de préférence 0,5*P < K < 0,95*P, de préférence 0,75*P < K < 0,9*P.

7. Actionneur à empilement piézoélectrique (1) selon l'une quelconque des revendications 4 à 6, **caractérisé en ce que** l'actionneur à empilement (1) présente au moins l'une des caractéristiques suivantes :
a. au moins un élément supplémentaire (3) est agencé entre deux actionneurs (2) voisins, dans lequel l'élément supplémentaire (3) est formé de préférence sous la forme d'une électrode.
b. au moins deux actionneurs (2) voisins sont connectés directement ou indirectement par l'intermédiaire d'un élément supplémentaire (3), de préférence en formant une liaison par complémentarité de matière entre les actionneurs (2) voisins ou entre chacun des actionneurs (2) voisins et l'élément supplémentaire (3) disposé entre eux, de préférence au moyen d'un adhésif, dans lequel l'adhésif colle de manière particulièrement préférée la au moins une surface de couplage (K).
c. au moins deux actionneurs (2) voisins, à l'extérieur de la au moins une surface de couplage (K), sont découplés l'un de l'autre, de préférence dans la zone de bord, de préférence dans le plan de couplage, de manière particulièrement préférée par élimination de matériau de piézo-céramique et/ou d'adhésif et/ou en appliquant un agent de démoulage avant le collage.
d. les électrodes (25, 26) des actionneurs (2) de même polarité sont connectées entre elles par une partie de connexion (11), dans lequel la partie de connexion est de préférence appliquée sur les électrodes (25, 26).
